# EUROPEAN PATENT APPLICATION

(11) **EP 4 614 539 A1**
(43) Date of publication of application: **10.09.2025**
(21) Application number: 23885815.3
(22) Date of filing: 01.11.2023
(51) Int. Cl.: H01G 7/02, H02N 1/08, H10N 30/06, H10N 30/30, H10N 30/87

(54) **ELECTRET MATERIAL AND SKIN-PATCH TYPE ELECTRET ENERGY HARVESTING DEVICE USING SAME**

(30) Priority: 04.11.2022 JP 2022177440; 15.09.2023 JP 2023150068
(71) Applicant: The University of Tokyo, Bunkyo-ku, Tokyo 113-8654 (JP); AGC INC., Chiyoda-ku, Tokyo 1008405 (JP)
(72) Inventor: SUZUKI, Yuji, Tokyo 113-8654 (JP); SUZUKI, Kuniko, Tokyo 113-8654 (JP); KASHIWAGI, Kimiaki, Tokyo 100-8405 (JP); SUGIYAMA, Norihide, Tokyo 100-8405 (JP); HATTORI, Yukiko, Tokyo 100-8405 (JP); OKAZOE, Takashi, Tokyo 100-8405 (JP)
(74) Representative: TBK
(86) International application number: PCT/JP2023/039437
(87) International publication number: WO 2024/096061

(57) **Abstract**

[Problem] Provided are an electret material which has high charge retention ability and elasticity, and a skin-patch type electret energy harvesting device using the same.

[Solution] An iodine- and/or bromine-containing perfluoroelastomer or a crosslinked elastomer formed by crosslinking this elastomer, is used an electret material. These materials have elasticity and are capable of forming an electret by being charged by means of a soft X-ray. In addition, a skin-patch type electret energy harvesting device is obtained by forming the electret on one of two comb-shaped electrodes that are arranged to be parallel to each other.

## Description

### Technical Field

The present disclosure relates to an electret material and a skin-patch type electret energy harvesting device using the same.

### Background Art

An electret is a charged dielectric material capable of generating an electric field almost permanently. An electret energy harvesting device is an element which converts vibrations in the environment to electric power by electrostatic induction using an electret's electric field. Low-frequency vibrations such as environmental vibrations, human body vibrations caused by walking, etc., of a person, can be efficiently converted to electric power, and high output power can be obtained. Therefore, the electret energy harvesting device is being noticed as a batteryless power source capable of continuously driving a low power consumption electronic device such as a wearable device, a wireless sensor, etc. For example, Patent Document 1 mentioned below discloses a charging device and a charged body manufacturing method capable of charging a dielectric material, by a short-time charging process, so that its surface potential is high and stable over time.

However, the power output of the electret power generation device is in proportion to a square of the surface potential of the electret, and the durability and the heat resistance of the device are largely influenced by the charging characteristics of the electret. Accordingly, in order to improve the performance of the electret power generation device, it is necessary to develop an electret material capable of stably holding more electric charges for a long time.

For example, Patent Document 2 discloses an example of using an electret material made of CYTOP (registered trademark) which is a polymer having a fluorine-containing aliphatic ring structure in the main chain. Also, Patent Document 3 discloses an example of using an electret material made of CYTOP (registered trademark) in which 2, 2', 2"-triaminotriethylamine is bonded to the terminal group.

Further, in the conventional electret power generation device, the electret faces a collecting electrode, the area of the overlapping part or the distance between the facing surfaces is changed over time, and the induced current is taken out to an external circuit for power generation. For example, Patent Document 2 mentioned below discloses an example in which CYTOP (registered trademark) is used for the electret material, and a strip-shaped electret and the collecting electrode are relatively moved in the horizontal direction to change the area of the overlapping part.

On the other hand, the skin-patch type electronic device is also referred to as skin electronics, and its expansion to various fields such as an information terminal integrating the human body and the electronic device, in-home care by acquiring data of a living body from skin, soft robotics, and the like, has been considered. Thus, in order to prevent the discomfort caused when the device is adhered to the skin, having flexibility as well as elasticity is required for the device. For example, Patent Document 4 mentioned below discloses an example of a circuit board which realizes the flexibility and the elasticity by forming wires and functional members on one face of a base having an uneven cross-section and provided with a stress adjusting layer.

### Prior Arts

Patent Document 1: WO 2012/053617 pamphlet
Patent Document 2: Japanese Unexamined Patent Publication (Kokai) No. 2011-91996
Patent Document 3: Japanese Unexamined Patent Publication (Kokai) No. 2020-65055
Patent Document 4: Japanese Unexamined Patent Publication (Kokai) No. 2019-75409

### Summary

The above-mentioned conventional electret material does not have sufficient elasticity, and thus, in particular, using the conventional electret material to a skin-patch type electret energy harvesting device is difficult. Further, according to the structure of the conventional energy harvesting device, a substrate on which the electret is arranged and a substrate on which the collecting electrode is arranged should be relatively moved, which leads to a complex structure. Thus, applying such a conventional energy harvesting device to a skin-patch type electret energy harvesting device is difficult.

One of the objectives of the present disclosure is to provide an electret material having a high charge retention ability and having elasticity, and to provide a skin-patch type electret energy harvesting device using the same.

In order to attain the above objectives, the present disclosure includes the following aspect.
[1] An electret material which is a perfluoroelastomer having a repeating unit based on tetrafluoroethylene, and a repeating unit based on CF₂=CF-O-R^{f} (in the formula, R^{f} represents a perfluoroalkyl group having 1 to 20 carbon atoms, which may have an ether-based oxygen atom), and the perfluoroelastomer being an iodine- and/or bromine-containing perfluoroelastomer.
[2] An electret material which is a perfluoroelastomer formed as a polymer of at least one type of perfluoromonomer selected from a group consisting of tetrafluoroethylene and CF₂=CF-O-R^{f}, and an iodine- and/or bromine-containing monomer, and the perfluoroelastomer being an iodine- and/or bromine-containing perfluoroelastomer.
[3] An electret material which is a perfluoroelastomer formed as a copolymer of at least one type of perfluoromonomer selected from a group consisting of tetrafluoroethylene and CF₂=CF-O-R^{f}, with one or both of an iodine- and/or bromine-containing monomer and a compound represented by I-R^{f2}-I (in the formula, R^{f2} represents a perfluoroalkylene group having 1 to 8 carbon atoms, which may have an ether-based oxygen atom), and the perfluoroelastomer being an iodine- and/or bromine-containing perfluoroelastomer.
[4] An electret material according to [1], wherein the iodine- and/or bromine-containing perfluoroelastomer is crosslinked by a crosslinking aid containing a heteroatom in a molecule.
[5] An electret material according to [4], wherein the crosslinking aid is triallyl isocyanurate.
[6] A skin-patch type electret energy harvesting device using a single substrate, comprising;
   a substrate having elasticity, one main face of the substrate being adherable to skin,
   two comb-shaped electrodes formed on the other main face of the substrate, and arranged to be in parallel with each other, and
   an electret formed on one of the comb-shaped electrodes,
   wherein an electret comprises the electret material according any one of [1] to [5], and an amount of induced charge by a fringe field of static electricity is changed by changing a horizontal direction gap between the electrode and the electret.

According to the present disclosure, an electret material having a high charge retention ability and having elasticity, and a skin-patch type electret energy harvesting device using the same and having a simple structure with a single substrate, can be provided.

### Brief Description of Drawings

FIG. 1 is a perspective view showing a structural example of a skin-patch type electret energy harvesting device according to the present disclosure.
FIG. 2 is a cross-sectional view explaining operations of a skin-patch type electret energy harvesting device according to the present disclosure.
FIG. 3 is an explanatory view explaining a charging process of an electret material.
FIG. 4 shows a measurement result of time-varying surface potential of an electret.
FIG. 5 is a structural overview showing a measurement method of a thermally stimulated current (TSD).
FIG. 6 is a view showing a TSD spectrum of a TSD measurement result.
FIG. 7 is a view showing an evaluation result regarding stability of the charge trapped in the electret, against the stretching/contracting operation.
FIG. 8 is a view showing an output current waveform of a skin-patch type electret energy harvesting device according to an aspect of the present disclosure.

### Aspects of the Disclosure

Hereinbelow, aspects of the present disclosure (hereinbelow, referred to as aspects) will be explained with reference to the drawings.

The electret material according to the present disclosure is a perfluoroelastomer having a repeating unit based on tetrafluoroethylene (hereinbelow, referred to as TFE), and a repeating unit based on CF₂=CF-O-R^{f} (in the formula, R^{f} represents a perfluoroalkyl group which may have an ether-based oxygen atom, and which has a carbon atom number of 1 to 20), which is an iodine- and/or bromine-containing perfluoroelastomer.

One kind, or two more kinds of CF₂=CF-O-R^{f} can be used. CF₂=CF-O-CF₃, CF₂=CF-O-CF₂CF₃, CF₂=CF-O-CF₂CF₂CF₃, CF₂=CF-O-CF₂CF(CF₃)OCF₂CF₂CF₃, CF₂=CF-O-CF₂CF₂-O-CF₂CF₃, etc., are preferable, and CF₂=CF-O-CF₃ is more referable.

Further, the carbon atom number of R^{f} is preferably 1 to 20, and more preferably 1 to 8.

A preferable copolymerization ratio of the fluorine-containing copolymer (perfluoroelastomer) is TFE-based repeating unit/CF₂=CF-O-R^{f}-based repeating unit = 30 to 80/70 to 20 (molar ratio). If the copolymerization ratio satisfies this range, a superior rubber property can be obtained.

Using a perfluoroelastomer substantially free from hydrogen atoms is preferable, but a perfluoroelastomer obtained by using a chain transfer agent or a comonomer containing a small amount of hydrogen atoms can also be used. Examples of the chain transfer agent containing a hydrogen atom include: chain or cyclic saturated hydrocarbons such as methane, ethane, propane, butane, pentane, hexane, cyclohexane, etc., alcohols such as methanol, ethanol, propanol, etc., and mercaptans such as tert-dodecyl mercaptan, n-dodecyl mercaptan, n-octadecyl mercaptan, etc. One kind of, or two or more kinds of the chain transfer agent can be used.

Examples of the comonomer containing a hydrogen atom includes: CF₂=CF-O-CH₂CF₃, CF₂=CF-O-CH₂CF₂CF₂CF₃, CF₂=CF-O-CH₂(CF₂CF₂)₂H, CF₂=CF-O-CF₂CF₂CH₂-I, CF₂=CF-O-CF₂CF₂CH₂-Br, CF₂=CF-O-CF₂CF₂(CF₃)-O-CF₂CF₂CH₂-I, CF₂=CF-O-CF₂CF₂(CF₃)-O-CF₂CF₂CH₂-Br, etc. One kind of, or two or more kinds of the comonomer containing a hydrogen atom can be used. In this regard, if the content of the hydrogen atom increases, the properties of the perfluoro rubber, such as a heat resistance, a chemical resistance, etc., are decreased, and further, the volume resistivity is decreased resulting in the decrease in the electrical insulation ability and the charge retention ability of the electret.

Accordingly, the content of the hydrogen atom in the perfluoroelastomer used in the present disclosure is 0.1% by mass or less, preferably 0.07% by mass or less, and more preferably 0.05% by mass or less.

For the perfluoroelastomer, a perfluoroelastomer obtained by copolymerizing fluorodiene as a comonomer, can also be used. The fluorodiene is a compound having one or more fluorine atom, having two polymerizable double bonds, and having no cyclic polymerization ability.

The fluorodiene can be a perfluorodiene composed of a carbon atom and a fluorine atom, a perfluorodiene composed of a carbon atom, a fluorine atom, and an oxygen atom, a fluorodiene having a hydrogen atom, and the like. From the viewpoint that the cross-linking substance has a superior heat resistance and chemical resistance, the fluorodiene is preferably a perfluorodiene, more preferably a perfluorodiene composed of a carbon atom, a fluorine atom, and an oxygen atom, and most preferably, a perfluorodiene having a perfluorovinyl ether group.

Specific examples of the perfluorodiene having a perfluorovinyl ether group includes:
CF₂=CFO(CF₂)₃OCF=CF₂, CF₂=CFO(CF₂)₄OCF=CF₂,
CF₂=CFO(CF₂)₅OCF=CF₂, CF₂=CFO(CF₂)₆OCF=CF₂,
CF₂=CFO(CF₂)₄OCF(CF₃)CF₂OCF=CF₂, and the like.

When a perfluoroelastomer has a fluorodiene-based constituent unit, the perfluoroelastomer has a branched structure, and the number of polymer terminal groups per molecule exceeds 2 in average. Therefore, in case of a perfluoroelastomer having an iodine atom or a bromine atom at the polymer chain terminal, a perfluoroelastomer composition containing a perfluoroelastomer having a fluorodiene-based constituent unit has a superior crosslinking reactivity, compared to a perfluoroelastomer composition containing a linear perfluoroelastomer having no branch

In the perfluoroelastomer, the content of the fluorodiene-based constituent unit, relative to the all constituent units in the perfluoroelastomer, is preferably 0.01 to 5 mol%, more preferably 0.01 to 3 mol%, and most preferably 0.05 to 1 mol%.

The electret material according to the present disclosure is: a perfluoroelastomer which is a polymer of at least one kind of perfluoromonomer selected from a group consisting of tetrafluoroethylene and CF₂=CF-OR^{f}, and a iodine- and/or bromine-containing monomer, the perfluoroelastomer being iodine- and/or bromine-containing perfluoroelastomer; or a perfluoroelastomer which is a copolymer of at least one kind of perfluoromonomer selected from a group consisting of tetrafluoroethylene and CF₂=CF-O-R^{f}, with one or both of an iodine- and/or bromine-containing monomer, and compounds represented by I-R^{f2}-I (in the formula, R^{f2} represents a perfluoroalkylene group having a carbon number of 1 to 8 which may have an ether-based oxygen atom), the perfluoroelastomer being iodine- and/or bromine-containing perfluoroelastomer.

Examples of the iodine- and/or bromine-containing monomer include : CF₂=CFBr, CH₂=CHCF₂CF₂Br, CF₂=CF-O-CF₂CF₂-I, CF₂=CF-O-CF₂CF₂-Br, CF₂=CF-O-CF₂CF₂CH₂-I, CF₂=CF-O-CF₂CF₂CH₂-Br, CF₂=CF-O-CF₂CF₂(CF₃)-O-CF₂CF₂CH₂-I, CF₂=CF-O-CF₂CF₂(CF₃)-O-CF₂CF₂CH₂-Br, and the like.

Specific examples of the I-R^{f2}-I include: diiododifluoromethane, 1,2-diiodoperfluoroethane, 1,3-diiodoperfluoropropane, 1,4-diiodoperfluorobutane, 1,5-diiodoperfluoropentane, 1,6-diiodoperfluorohexane, 1,7-diiodoperfluoroheptane, 1,8-diiodoperfluorooctane, and the like. Among these, 1,4-diiodoperfluorobutane and 1,6-diiodoperfluorohexane are preferable, and 1,4-diiodoperfluorobutane is particularly preferable.

The content of the iodine and/or bromine in the perfluoroelastomer of the present disclosure is not particularly limited, but the content is preferably 0.1 to 1.5% by mass, more preferably 0.1 to 1.0% by mass, and particularly preferably 0.2 to 1.0% by mass. In these ranges, a composition capable of providing crosslinked rubber having a superior rubber property such as tensile strength, stretch, rebound resilience, compression set, and the like.

The perfluoroelastomer used in the present disclosure has a glass transition temperature (hereinbelow, referred to as Tg) is 15°C or less, preferably -50 to 10°C, more preferably -50 to 0°C, and most preferably -50 to -3°C.

The iodine- and/or bromine-containing perfluoroelastomer which is the electret material according to the present disclosure is preferably crosslinked by a crosslinking aid containing a heteroatom in a molecule.

For the crosslinking of the iodine- and/or bromine-containing perfluoroelastomer composition according to the present disclosure, containing a crosslinking aid is preferable. If the crosslinking aid is contained, the crosslinking efficiency is high. Specific examples of the crosslinking aid include: triallyl cyanurate, triallyl isocyanurate (TAIC), trimethacrylic isocyanurate, 1,3,5-triacryloylhexahydro-1,3,5-triazine, triallyl trimellitate, m-phenylenediamine-bis-maleimide, p-quinone dioxime, p,p'-dibenzoylquinone dioxime, dipropargyl terephthalate, diallyl phthalate, N,N',N",N‴-tetraaryl terephthalamide, vinyl group-containing siloxane oligomers such as polymethylvinylsiloxane, polymethylphenylvinylsiloxane, and the like.

In particular, triallyl cyanurate, triallyl isocyanurate, trimethacrylic isocyanurate are preferable, and triallyl isocyanurate (TAIC) is more preferable. The content of the crosslinking aid, relative to 100 parts by mass of perfluoroelastomer, is preferably 0.1 to 10 parts by mass, and more preferably 0.5 to 5 parts by mass. In these ranges, a cross-linking property having a preferable balance of strength and stretch can be obtained.

Further, by using s crosslinking aid containing a heteroatom, a charge trapping structure can be introduced to the perfluoroelastomer, and thus, the positive charge and the negative charge can be stably maintained.

The perfluoroelastomer according to the present disclosure can be hardened by performing crosslinking reaction using an organic peroxide, under the presence of the crosslinking aid.

The organic peroxide is not particularly limited, but the organic peroxide having a one minute half-life temperature, that is, the temperature at which the half amount of the organic peroxide decomposes, of 150 to 250°C is preferable, and 150 to 200°C is more preferable. Specific examples include: dialkyl peroxides such as di-tert-butyl peroxide, tert-butyl cumyl peroxide , dicumyl peroxide, α,α-bis(tert-butylperoxy)-p-diisopropylbenzene, 2,5-dimethyl 2,5-di(tert-butylperoxy) hexane, 2,5-dimethyl 2,5-di(tert-butylperoxy)hexane-3, 1,3-bis(tert-butylperoxy isopropyl)benzene, 1,1-di(tert-butylperoxy)-3,3,5-trimethyl cyclohexane, 2,5-dimethylhexane-2,5-dihydroxy peroxide, benzoyl peroxide, tert-butylperoxy benzene, 2,5-dimethyl 2,5-di(benzoylperoxy)hexane, tert-butylperoxy maleic acid, tert-butylperoxy isopropyl carbonate, and the like. One kind or two more kinds of organic peroxides can be used .

The addition amount of the organic peroxide, relative to 100 parts by mass of the perfluoroelastomer according to the present disclosure, is preferably 0.05 to 10 parts by mass, more preferably 0.3 to 5 parts by mass, and most preferably 0.5 to 3 parts by mass. In these ranges, a composition capable of providing a fluorine-containing rubber product made of a crosslinked rubber having a superior heat resistance and rubber property.

The iodine- and/or bromine-containing perfluoroelastomer, which is the electret material according to the present disclosure, is an amorphous fluorine-containing elastomer having elasticity, and being superior in chemical resistance, heat resistance, weather resistance, and mechanical strength. Further, the iodine- and/or bromine-containing perfluoroelastomer has Young's modulus of approximately 1 MPa which is within the Young's modulus of human skin, i.e., Young's modulus of 0.5 to 1.95 MPa. Thus, the perfluoroelastomer does not prevent the elasticity of the skin, and thus, is comfortable to the skin. Therefore, this is preferable as a material for a skin-patch type electret energy harvesting device. The same is true in the case that the iodine- and/or bromine-containing perfluoroelastomer is crosslinked.

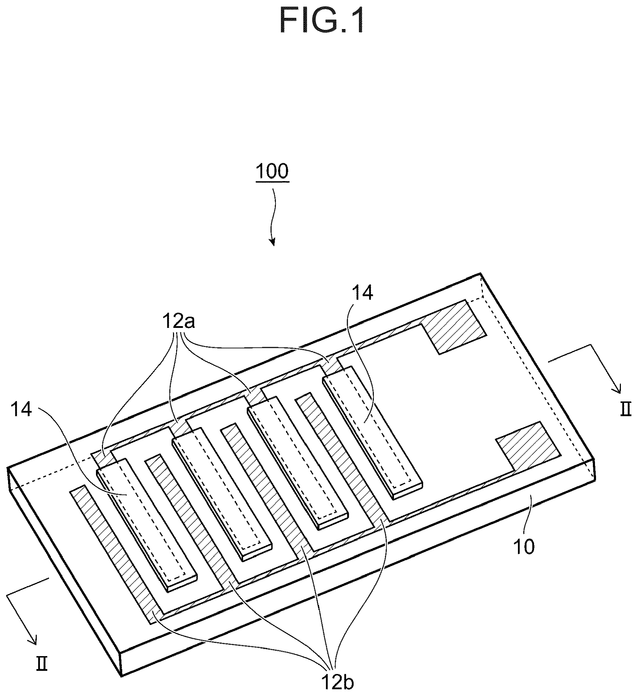

Another aspect of the present disclosure is a skin-patch type electret energy harvesting device. FIG. 1 shows a perspective view of a structural example of the skin-patch type electret energy harvesting device according to the present disclosure. In FIG. 1, a skin-patch type electret energy harvesting device 100 has an elastic substrate 10 made of silicone rubber, etc., one main face of substrate 10 (the rear face in the drawing) being attachable to the human skin by an adhesive, etc., and the other main face (the front face in the drawing) of the substrate 10 being provided with a pair of comb-shaped electrodes 12a, 12b arranged to be substantially parallel with each other. For the attachment to the skin, using an adhesive agent suitable for adhering to the skin, such as an adhesive agent for medical use, etc., having a small influence on the skin, is preferable. For example, a urethane adhesive agent for skin, manufactured by AGC Inc., can be used. Further, an electret 14 is formed on one comb-shaped electrodes 12a of the pair (two) comb-shaped electrodes 12a, 12b.

The electret 14 is formed by using the above-mentioned iodine- and/or bromine-containing perfluoroelastomer (including the crosslinked one) as an electret material, and charging a positive charge by soft X-rays. Here, a negative charge can be charged.

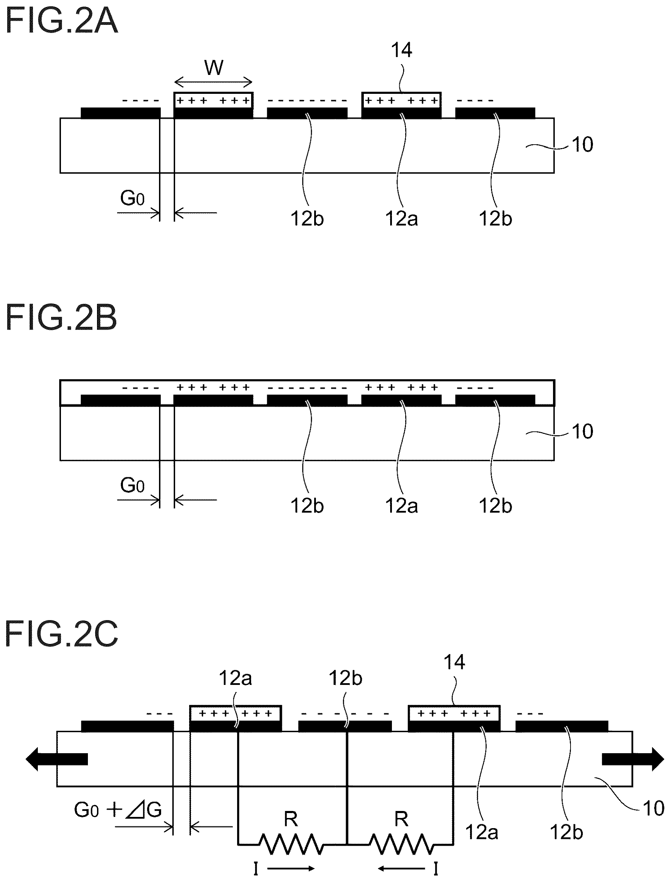

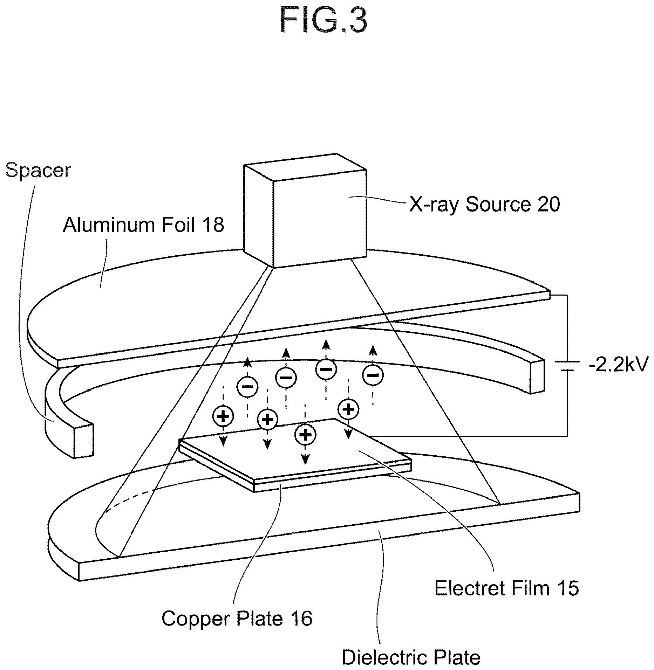

FIG. 2A, 2B, and 3C show cross-sectional views explaining the operations of the skin-patch type electret energy harvesting device according to the present disclosure. FIG. 2A and FIG. 2C are cross-sectional views along II-II in FIG. 1. In FIG. 2A, the horizontal-direction distance between the comb-shaped electrode 12b and the electret 14 formed on the comb-shaped electrode 12a is G₀. Due to the effects caused by the positive charge of the electret 14 formed on the comb-shaped electrode 12a, an electric field (fringe field) is generated, and due to this fringe field, a negative charge is induced to the comb-shaped electrode 12b. When stretching and contracting occur between the state that the substrate 10 is stretched (the horizontal direction distance between the comb-shaped electrode 12b and the electret 14 is G₀+ΔG₀) as shown in FIG. 2C, and the state that the substrate 10 is in the initial state as shown in FIG. 2A, the horizontal direction distance between the comb-shaped electrode 12b and electret 14 varies (varies between G₀ and G₀+ΔG₀), and thus, the amount of induced charge induced to the comb-shaped electrode 12b varies. Thereby, an induced current I is generated, which can be extracted to an external circuit as power output. Therefore, the skin-patch type electret energy harvesting device according to the present disclosure, power generation can be performed by stretching and contracting a single substrate to change the horizontal direction distance between the comb-shaped electrode 12b and the electret 14 and to change the amount of induced charge by the fringe field of the static electricity. Accordingly, if the skin-patch type electret energy harvesting device of the present disclosure is adhered to the human skin, electric power can be extracted by the stretching and contracting movement of the skin generated along with the human activities.

In FIG. 2A and FIG 2C, the electrets 14 are formed only on the comb-shaped electrodes 12a. However, the same operations can be performed when the electret 14 is formed on the entire face including the parts on the comb-shaped electrodes 12b, and the charges are injected only on the comb-shaped electrodes 12a or charges of opposite signs are injected on the comb-shaped electrodes 12a and the comb-shaped electrodes 12b, respectively, as shown in FIG. 2B.

### Examples

Hereinbelow, examples of the present disclosure are specifically explained. The below-mentioned examples are explained for the purpose of easy understanding of the present disclosure. The present disclosure is not limited to these examples.

### <Preparation of Samples>

(a) As an example of the electret material, for the iodine- and/or bromine-containing perfluoroelastomer, AFLAS (registered trademark) PM-1100 manufactured by AGC Inc. was used (Example 1). Further, as another example of the electret material, a crosslinked elastomer obtained by crosslinking the AFLAS (registered trademark) PM-1100 with triallyl isocyanurate (TAIC, manufactured by Combi-Blocks Inc.) was used (Example 2).

In Example 2, preparation of a crosslinking composition is performed as follows. Using a 50 mlround-bottom flask, AFLAS (registered trademark) PM-1100, TAIC, and 2,5-dimethyl 2,5-di(tert-butyl peroxy)hexane (DBPH, manufactured by Acros Organics) as an initiator, were mixed in a fluorine-based solvent (Product Name: ASHIKLIN AC2000, manufactured by AGC Inc.), and the mixture was stirred at 35°C for one hour for dissolving. The resultant was further stirred at 90°C for 30 minutes. Next, the mixed solution was placed in an inert oven to remove the solvent by evaporation under an atmosphere of nitrogen. Thereby, a crosslinking elastomer composition was obtained.

As a comparative example of the electret material, polydimethylsiloxane (PDMS) was used (Example 3).

The crosslinking composition in Example 2 was pressed using a small press machine (H300-10D, manufactured by AS ONE Corporation) at 170°C, 10 MPa, for 15 minutes, and thereby a cured film of a crosslinked elastomer was obtained. Further, the material in Example 1 was also pressed under the same conditions as Example 2, and a free-standing film was obtained.

(b) The film formed by using each resin of the electret materials was charged, to form an electret. Here, the electret of Example 1 had a film thickness of 18.5 µm, the electret of Example 2 had a film thickness of 75 µm, and the electret of Example 3 had a film thickness of 53 µm. FIG. 3 is an explanatory view showing the charging process. In FIG. 3, a film 15 according to each of Example 1 to Example 3 is placed on a copper plate 16, and a bias voltage of -2.2 kV is applied from an external power source to the space between each film and an aluminum foil 18 arranged above the film. Under these conditions, soft X-rays are irradiated from a soft X-ray source 20 (HAMAMATSU PhotoIonizer L9490) to ionize nitrogen molecules in the air, and thus, nitrogen ions are attracted to the film by the bias voltage. The surface potential of the film gradually cancels the bias voltage, and when the surface potential of the film becomes equal to the bias voltage, the charging is complete, and the electret according to Example 1 to Example 3 is formed. Each of the electret of Example 1 to Example 3 formed as above has an initial surface potential of approximately 2.2 kV.

### <Performance Evaluation>

### (c) Tensile Test

Each of the films (before charging) according to Example 1 to Example 3 produced by the above (a), was stretched at an elongation rate of 1 mm/min, using a compact tabletop tester (EZ-SX, manufactured by Shimadzu Corporation), and Young's modulus of each film was measured.

Regarding the films used in the test, the film of Example 1 has a size of length 11 mm × width 0.5 mm (thickness 0.5mm), the film of Example 2 has a size of length 25 mm × width 1 mm (thickness 0.075 mm), and the film of Example 3 has a size of length 7 mm × width 3 mm (thickness 0.05 mm).

The film of Example 1 was broken when the film was stretched at 190%. The Young's modulus until the 70% strain was approximately 1 MPa, and thereafter, the film was plastic-deformed. The film of Example 2 was almost linearly stretched until 180%, and then, was broken. No apparent yield points were found until the film was broken, and the Young's modulus was approximately 1 MPa. The film of Example 3 was stretched until 165%, and then, as broken. No apparent yield points were found until the film was broken, but the inclination became large around the 50% stretch. The Young's modulus until the 50% strain was approximately 1 MPa, and the Young's modulus after the 100% strain was approximately 3 MPa.

From the above, it was confirmed that each of the film of Example 1 and the film of Example 2 had a Young's modulus of approximately the same as the Young's modulus of human skin. Further, regarding the film of Example 2, no yield points were found until the film is broken, and the film returned to the original length after it was stretched. Therefore, the film of Example 2 has preferable properties as a stretching/contracting electret film.

(d) Regarding each of the electrets according to Example 1 to Example 3 produced by the above (b), a time dependent change of the surface potential was measured by using MONROE ELECTRONICS ISOPROBE ELECTROSTATIC VOLTMETET Model 279.

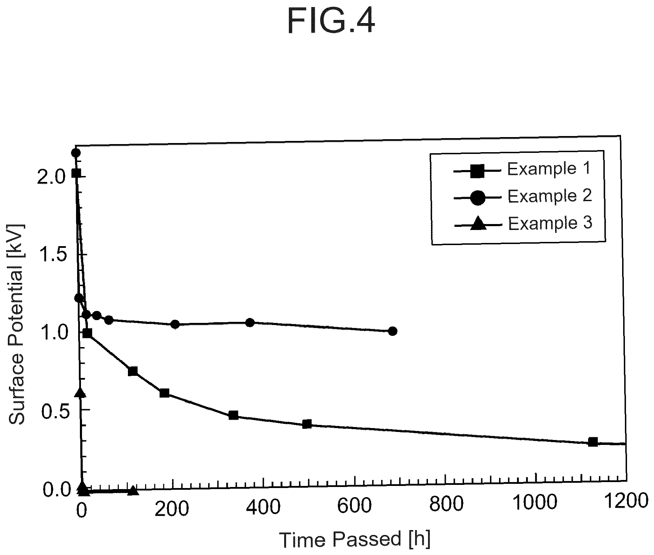

FIG. 4 shows the measurement results. In FIG. 4, the vertical axis indicates the surface potential, the horizontal axis indicates the time passed from the completion of the charging.

As shown in FIG. 4, the electret of Example 3 shows an acute decrease of the surface potential, and the surface potential disappears within an hour. On the other hand, the electret of Example 1 has an initial surface potential of 2.0 kV, and has a surface potential after 1200 hours of 0.25 kV. Further, the electret of Example 2 has an initial surface potential of 2.2 kV, and has a surface potential after 700 hours of 1.0 kV.

From the above, it is confirmed that the electret of Example 1 and the electret of Example 2 can maintain the surface potential for sufficiently a long time.

(e) Regarding each of the electret of Example 1 and the electret of Example 2 produced by the above (b), a thermally stimulated discharge (TSD) was measured, for the purpose of evaluating the thermal stability of the trapped charge.

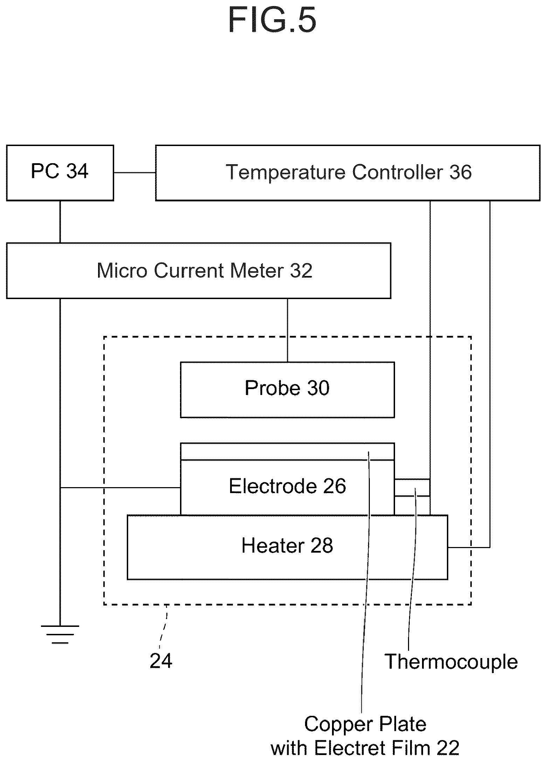

FIG. 5 shows a schematic structure (self-made device) for the TSD measurement. In FIG. 5, a copper plate 22 on which each electret, i.e., a sample, is placed, is fixed to an electrode 26 in a metal measurement chamber 24. The temperature is increased by a heater 28, from 40°C to 200°C at 1°C/min, and the change in the amount of induced charge (thermally stimulated discharge (TSD) current value) of a probe electrode 30 is measured by the micro current meter (Keithley 6430, manufactured by Keithley Instruments Inc.) 32. Here, the temperature of the electret is controlled by adjusting the operation of the heater 28 by a temperature controller 36 controlled by a computer 34.

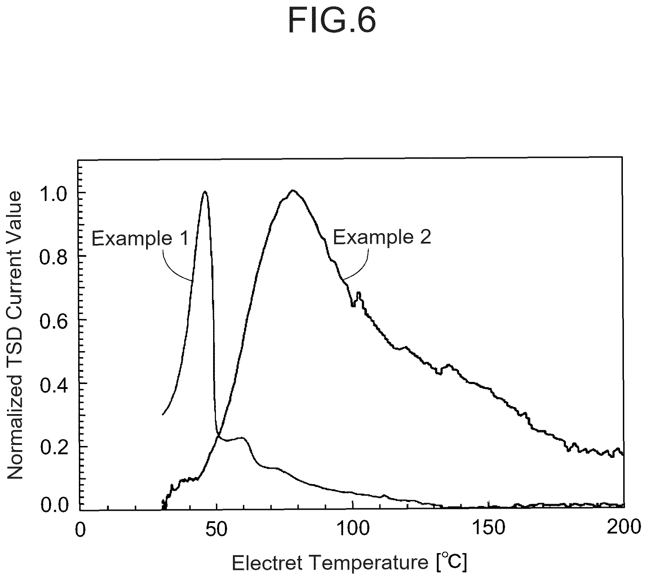

FIG. 6 shows TSD spectra of the measurement results. In FIG. 6, the vertical axis indicates the normalized TSD current value, and the horizontal axis indicates the temperature of the electret. The TSD spectrum shown in FIG. 6 represents the amount of charge discharged from the electret (detrapped charge) by the TSD current, and the peak emerges at the temperature at which the largest amount of charge is discharged. Accordingly, the higher the peak temperature, the higher the thermal stability of the charge of the electret. Thus, the TSD spectrum can be an index showing the thermal stability of the charge trapped in the electret.

In FIG. 6, the temperature at which the peak of the TSD spectrum emerges (peak temperature) is 46°C in Example 1, and is 79°C in Example 2. Accordingly, it is made apparent that the thermal stability of the charge trapped in the electret is increased by crosslinking.

(f) Regarding the electret of Example 1 and the electret of Example 2 produced by the above (b), the stability of the trapped charge against the stretching and contracting operations was evaluated.

As a sample, each of the films according to Example 1 and Example 2 was formed into a size of 20 mm in length, 40 mm in width, and 0.12 mm in thickness, which was subjected to the charging operation by soft X-rays for 24 hours, and the charged film (electret) was fixed to the electromagnetic vibrator (APS-113, manufactured by APS DYNAMICS Inc.). Using the laser displacement sensor (LT-9500, manufactured by Keyence Corporation), the strain of the electret was measured, and at the same time, the electret was stretched and contracted at a constant vibration of 2 Hz.

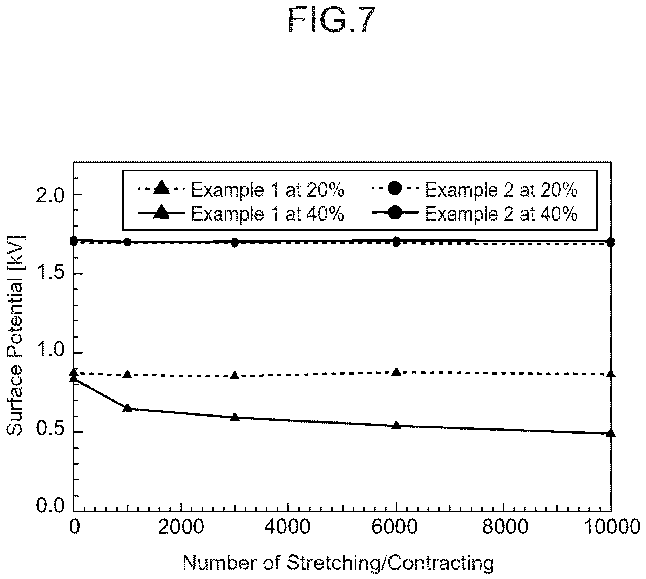

FIG. 7 shows evaluation results regarding the stability of the charge trapped in the electret, against the stretching/contracting operations. In FIG. 7, the vertical axis indicates the surface potential, and the horizontal axis indicates the number of stretching/contracting. As shown in FIG. 7, prior to the stretching/contracting test, the electret of Example 1 has a surface potential of 0.8 kV, and the electret of Example 2 has a surface potential of 1.7 kV.

Regarding both of the electret of Example 1 and the electret of Example 2, there are almost no change between the surface potentials after 10000 times of stretching/contracting at 20% strain and the initial values of the surface potentials. On the other hand, regarding the electret of Example 2, there is almost no change between the surface potential atter 10000 times of stretching/contracting at 40% strain and the initial value of the surface potential, and the electret shows a preferable stability. Whereas, regarding the electret of Example 1, the surface potential of the electret decreased 30% from the initial value. Accordingly, it is apparent that the stability of the charge trapped in the electret, against the stretching/contracting operation, can be increased by crosslinking.

As mentioned above, the electret of Example 2 is improved in terms of the stability of the trapped charge against the stretching/contracting operation, compared to the electret of Example 1. However, the electret of Example 1 is also sufficiently stable. Thus, it has been found that the electret of Example 1 and the electret of Example 2 have high stability of the trapped charge, against the stretching/contracting operation, and are suitable for the skin-patch type electret energy harvesting device.

### <Production and Evaluation of Skin-Patch Type Electret Energy Harvesting device>

(g) The film of Example 2 was used for the electret material, and the film was cut to have a size of length 20 mm × width 20 mm (thickness 0.125 mm). Using a polyimide substrate with a rectangular hole as a hard mask, a copper thin film having a thickness of 200 nm was formed, by electron beam evaporation, on one of the main faces of the film, to form only one pair of comb-shaped electrodes 12a, 12b, similar to FIG. 2B. For the electron beam evaporation, MUE-ECO-EB manufactured by Ulvac Inc. was used. The horizontal direction distance (gap) G₀ between the comb-shaped electrodes 12a and 12b was 2 mm. For the substrate 10, a silicone rubber sheet (manufactured by Togawa Rubber Co., Ltd.) having a thickness of 0.5 mm was used.

Similar to FIG. 2B, soft X-rays were irradiated to a region of the film of Example 2 corresponding to the comb-shaped electrodes 12a (a region above the comb-shaped electrodes 12a), by the charging process shown in FIG. 3, to form an electret having a surface potential of +2.5 kV, and to thereby form a skin-patch type electret energy harvesting device.

The skin-patch type electret energy harvesting device formed as above, was attached to the electromagnetic vibrator (APS-113, manufactured by APS DYNAMICS Inc.), and 10% strain was applied at a frequency of 1 Hz. At this time, the comb-shaped electrodes 12a, 12b were directly connected to a programmable current amplifier (CA5350, manufactured by NF Corporation), a short circuit current was converted to a voltage, and thereafter, the voltage was input, through an AD converter (TUSB0224ADM, manufactured by Turtle Industry Co., Ltd.), to a computer, and an output current waveform was recorded.

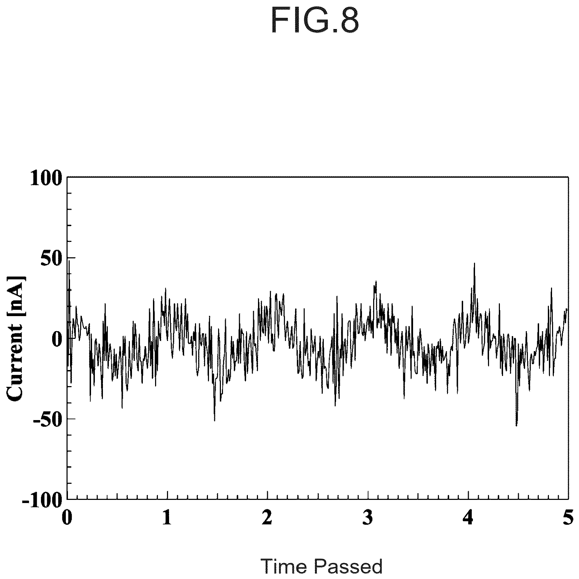

FIG. 8 shows the output current waveform of the skin-patch type electret energy harvesting device according to the present example. In FIG. 8, the vertical axis indicates the output current value, and the horizontal axis indicates the time passed. The skin-patch type electret energy harvesting device according to the present example has only a single pair of comb-shaped electrodes 12a, 12b, but still, as shown in FIG. **8****,** the peak value of the short circuit current is approximately 30 nA, which indicates that the energy harvesting device according to the present disclosure can be obtained.

### Industrial Applicability

The electret according to the present disclosure can be applied to an electrostatic induction type conversion element such as a power generator, microphone, etc., and in particular, is suitable for a skin-patch type electret energy harvesting device.

In addition, the entire contents of the specification, claims, drawings, and abstracts of Japanese Patent Application No. 2022-177440 filed on November 4, 2022 and Japanese Patent Application No. 2023-150068 filed on September 15, 2023 are cited herein and incorporated as the disclosure of the specification of the present disclosure.

### Explanation on Numerals

10 substrate, 12a, 12b comb-shaped electrode, 14 electret, 15 film, 16 copper plate, 18 aluminum foil, 20 soft X-ray source, 22 copper plate, 24 metal measurement chamber, 26 electrode, 28 heater, 30 probe electrode, 32 micro current meter, 34 computer, 36 temperature controller, 100 skin-patch type electret energy harvesting device.

## Claims

1. An electret material which is a perfluoroelastomer having a repeating unit based on tetrafluoroethylene, and a repeating unit based on CF₂=CF-O-R^{f} (in the formula, R^{f} represents a perfluoroalkyl group having 1 to 20 carbon atoms, which may have an ether-based oxygen atom), and the perfluoroelastomer being an iodine- and/or bromine-containing perfluoroelastomer.

2. An electret material which is a perfluoroelastomer formed as a polymer of at least one type of perfluoromonomer selected from a group consisting of tetrafluoroethylene and CF₂=CF-O-R^{f}, and an iodine- and/or bromine-containing monomer, and the perfluoroelastomer being an iodine- and/or bromine-containing perfluoroelastomer.

3. An electret material which is a perfluoroelastomer formed as a copolymer of at least one type of perfluoromonomer selected from a group consisting of tetrafluoroethylene and CF₂=CF-O-R^{f}, with one or both of an iodine- and/or bromine-containing monomer and a compound represented by I-R^{f2}-I (in the formula, R^{f2} represents a perfluoroalkylene group having 1 to 8 carbon atoms, which may have an ether-based oxygen atom), and the perfluoroelastomer being an iodine- and/or bromine-containing perfluoroelastomer.

4. An electret material according to claim 1, wherein the iodine- and/or bromine-containing perfluoroelastomer is crosslinked by a crosslinking aid containing a heteroatom in a molecule.

5. An electret material according to claim 4, wherein the crosslinking aid is triallyl isocyanurate.

6. A skin-patch type electret energy harvesting device using a single substrate, comprising;
a substrate having elasticity, one main face of the substrate being adherable to skin,
two comb-shaped electrodes formed on the other main face of the substrate, and arranged to be in parallel with each other, and
an electret formed on one of the comb-shaped electrodes,
wherein an electret comprises the electret material according any one of claim 1 to claim 5, and an amount of induced charge by a fringe field of static electricity is changed by changing a horizontal direction gap between the electrode and the electret.
